# EUROPEAN PATENT APPLICATION

(11) **EP 1 610 390 A2**
(43) Date of publication of application: **28.12.2005**
(21) Application number: 05076356.4
(22) Date of filing: 10.06.2005
(51) Int. Cl.: H01L 29/423, H01L 29/78, H01L 29/739

(54) **Semiconductor device with diagonal gate signal distribution runner**

(30) Priority: 22.06.2004 US 873429
(71) Applicant: Delphi Technologies, Inc., Troy, MI 48007 (US)
(72) Inventor: Hayes, Monty B., Kokomo, IN 46902 (US); Campbell, Robert J., Noblesville, IN 46060 (US); Fruth, John R., Kokomo, IN 46901 (US)
(74) Representative: Denton, Michael John

(57) **Abstract**

A semiconductor device (400A) includes a device body (400), a gate pad (412) and a gate signal distribution runner. The device body (400) includes a plurality of parallel cells and the gate pad (412) is located on a top surface of the device body (400) adjacent a corner of the device body (400). The gate signal distribution runner includes a peripheral gate signal distribution runner (413) extending around the periphery of the device body (400) from the gate pad (412) and a diagonal gate signal distribution runner (414) extending diagonally across the device body (400) from the gate pad (412). The gate signal distribution runner (413) provides a gate signal to a gate of each of the plurality of parallel cells.

## Description

### TECHNICAL FIELD

The present invention is generally directed to a semiconductor device and, more specifically, to a semiconductor device with a diagonal gate signal distribution runner.

### BACKGROUND OF THE INVENTION

Conventional metal-oxide semiconductor field-effect transistor (MOSFET) and insulated-gate bipolar transistor (IGBT) power devices have usually been designed with a cellular structure, which includes thousands of elementary cells integrated within a semiconductor die. Each cell has included a transistor which is connected in parallel to the transistors of the other cells to contribute to an overall current associated with the power device. In general, each cell includes a gate region, which is covered by a thin electrically insulative layer, e.g., a gate oxide layer. The gates of the cells are interconnected with a conductor, e.g., a polysilicon or metal layer, that is formed on a top surface of the device. The remaining top surface of the semiconductor device is typically covered by another conductor, which contacts and interconnects the source region of all of the cells. In general, the cellular structure allows for the achievement of relatively low voltage drop across the power device, i.e., low drain-to-source resistance, when it is in the on-state and, thus, relatively low power dissipation for the power device.

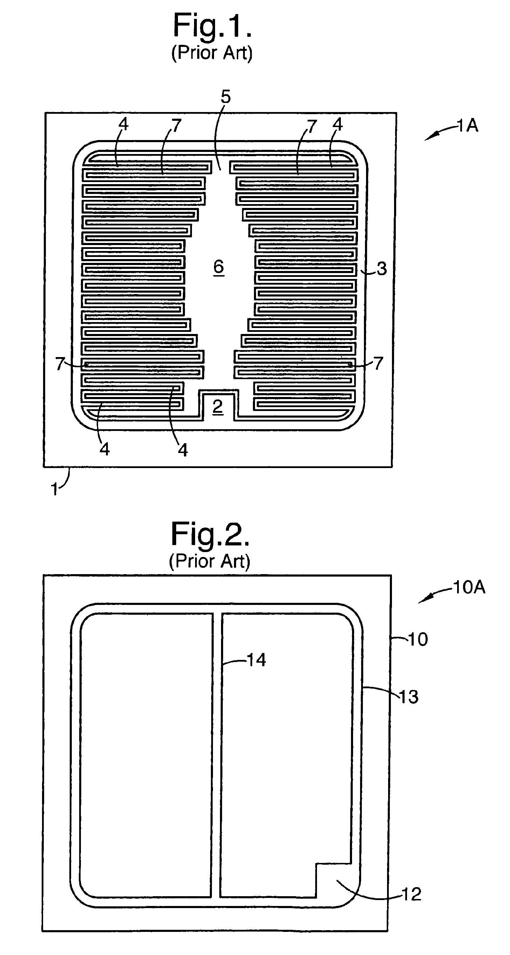

With reference to Fig. 1, a relevant portion of an exemplary prior art semiconductor device is illustrated. The device includes a substrate or device body 1, which includes a plurality of cells formed therein. A conductive gate pad 2 is centrally located along one edge of the substrate 1 and is connected to a conductive gate signal ring 3 that extends along a periphery of the substrate 1. Extending from the ring 3 are a plurality of conductive gate signal fingers 4, which are utilized provide a gate signal to a gate region of each of the cells. A conductive source plate 5 includes a central pad area 6 with source fingers 7 providing electrical connection to a source of each of the cells.

In general, designers have attempted to design gate signal ring and fingers to allow parallel cells within a semiconductor device to turn on and off with minimal propagation delay between the cells and to allow current to flow in a uniform manner across the power device. The gate signal runners have been made of a variety of materials, e.g., metals, polysilicon or a combination of metal and polysilicon, and have had various configurations depending on the physical dimensions and operating frequency of the device. For devices operating at lower frequencies, a relatively simple gate structure that traverses the periphery of the device has generally been suitable. However, devices operating at higher frequencies have generally required additional gate fingers (see Fig. 1) to allow for uniform propagation of the gate signal from a gate pad of the device to all of the parallel cells.

Gate pads have usually been centered along one of the edges of the semiconductor device or located at a center of the device. In a typical semiconductor device that implements wire bonding, the gate pad provides an interconnect point between the cells of the device and an external lead or device. Frequently, MOSFET (IGBT) devices are interconnected to external circuitry by soldering the drain (collector) and wire bonding the gate and source (gate and emitter) to other interconnects. Other solderable MOSFET devices, such as flip-chip devices, have been configured to allow for drain, source and gate interconnects to be achieved with a solder connection. Similarly, IGBT devices have been constructed such that collector, gate and emitter connections are made through a solder connection.

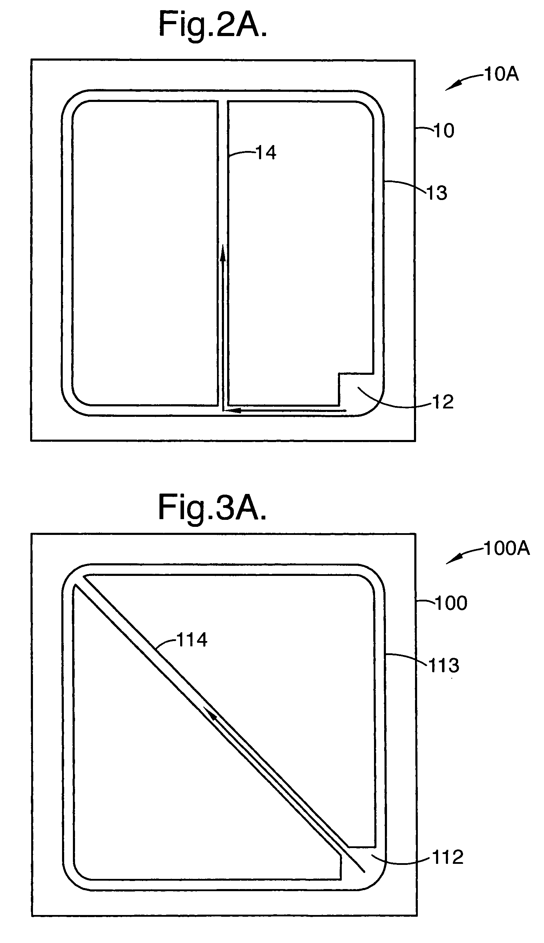

In semiconductor devices that have implemented solder connections, at least one such device has located a gate pad in a corner of the device. With reference to Fig. 2, a gate pad 12 is shown located at a corner of a device body 10. In this illustration, the source metallization is not shown. As is depicted, a gate signal ring 13 traverses the periphery of the device body 10 with an interconnected gate finger 14 traversing through a center of the device body 10 and connecting halves of the gate signal ring 13. While such a configuration is suitable for relatively low frequencies and low power, such a configuration may exhibit increased gate signal propagation delay to certain cells of the device at higher frequencies and/or higher powers. Unfortunately, as the gate signal propagation delay across the device becomes greater, the cells of the device do not uniformly turn on and off. This results in non-uniform current flow through the device, which can lead to device degradation and failures.

As such, it would be desirable to develop a technique that reliably allows high current and high power devices to achieve relatively uniform current flow through the device during switching events.

### SUMMARY OF THE INVENTION

According to the present invention, a semiconductor device includes a device body, a gate pad and a gate signal distribution runner. The device body includes a plurality of parallel cells and the gate pad is located on a top surface of the device body adjacent a corner of the device body. The gate signal distribution runner includes a peripheral gate signal distribution runner extending around the periphery of the device body from the gate pad and a diagonal gate signal distribution runner extending diagonally across the device body from the gate pad. The gate signal distribution runner provides a gate signal to a gate of each of the plurality of parallel cells.

These and other features, advantages and objects of the present invention will be further understood and appreciated by those skilled in the art by reference to the following specification, claims and appended drawings.

### BRIEF DESCRIPTION OF THE DRAWINGS

The present invention will now be described, by way of example, with reference to the accompanying drawings, in which:
Fig. 1 is top view of a relevant portion of an exemplary semiconductor device, with gate signal distribution runners configured according to the prior art;
Fig. 2 is top view of a relevant portion of another exemplary semiconductor device, with a gate signal distribution runner configured according to the prior art;
Fig. 2A is top view of the semiconductor device of Fig. 2 indicating the path of a gate signal to a center of the semiconductor device;
Fig. 3 is top view of an exemplary semiconductor device, with gate signal distribution runners configured according to the present invention;
Fig. 3A is top view of the semiconductor device of Fig. 3 indicating the path of a gate signal to a center of the semiconductor device;
Fig. 4 is top view of an exemplary semiconductor device, with gate signal distribution runners configured according to another embodiment of the present invention;
Fig. 5 is top view of an exemplary semiconductor device, with gate signal distribution runners configured according to a different aspect of the present invention; and
Fig. 6 is top view of an exemplary semiconductor device with gate signal distribution runners configured according to yet another embodiment of the present invention.

### DESCRIPTION OF THE PREFERRED EMBODIMENTS

According to various embodiments of the present invention, techniques are disclosed that allow a gate signal to be more uniformly provided to parallel cells of a semiconductor device, e.g., a metal-oxide semiconductor field-effect device (MOSFET) or an insulated-gate bipolar transistor (IGBT). According to the present invention, a diagonal gate signal distribution runner, that emanates from a corn.er of the device (where the gate pad is located) to an opposite corner of the device (traversing the triangle hypotenuse), is employed to uniformly distribute a gate signal to a gate region of each of a plurality of parallel cells. According to another embodiment of the present invention, for higher frequency MOSFET and IGBT applications where uniform gate impedance and propagation is even more desirable, additional gate signal distribution runners are added perpendicular to the diagonal gate signal distribution runner. It should be appreciated that the additional gate runners tend to further minimize gate impedance and allow for more uniform gate signal propagation across the device. For the sake of clarity, the source and drain connections are not shown in Figs. 2-6.

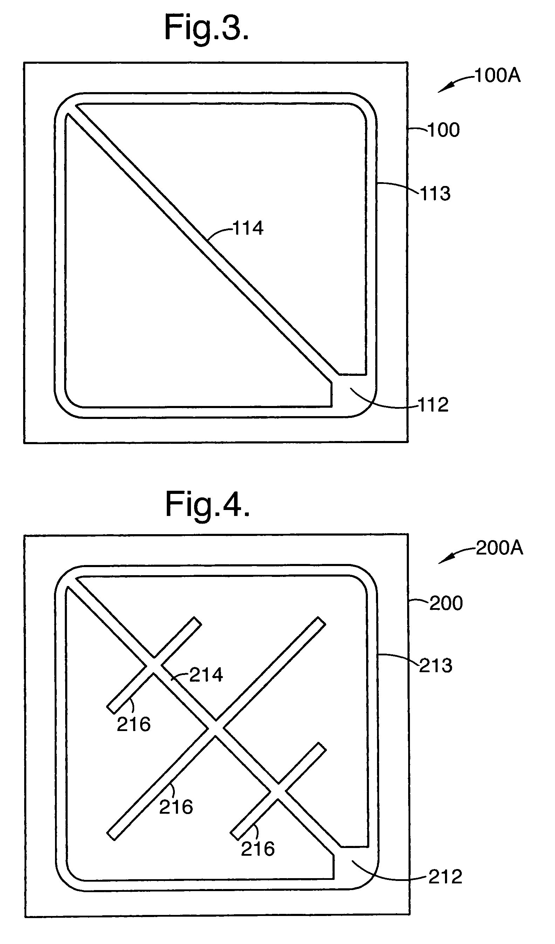

With reference to Fig. 3, a device body 100 of a semiconductor device 100A includes a gate pad 112 positioned at a corner of the device body 100, with a peripheral gate signal distribution runner 113 extending around the periphery of the device body 100 from the gate pad 112. As is also shown, a diagonal gate signal distribution runner 114 extends from the gate pad 112 across the device body 100 of the semiconductor device 100A.

With reference to Figs. 2A and 3A, it should be appreciated that the path length of a gate signal to a middle of the semiconductor device has been reduced. For example, assuming that the device bodies are square and have a side with length '2A', the gate signal path length to the center of the device body 100 of the device of Fig. 3 is equal to square root of two times A (2½ *A), as opposed to a gate signal path length of '2A' for the device body 10 of Fig. 2A. In sum, according to the present invention, shortening the length of the gate signal path results in a more uniform distribution of the gate signal across the device.

With reference to Fig. 4, a semiconductor device 200A having a device body 200 includes a gate signal distribution runner configured according to another embodiment of the present invention. As is shown, a gate pad 212 is located at one corner of device body 200, with a peripheral gate signal distribution runner 213 extending around a periphery of the device body 200. A diagonal gate signal distribution runner 214 extends from the gate pad 212 diagonally across the device body 200. As is shown, additional gate signal distribution runners 216 are positioned perpendicular to the diagonal gate signal distribution runner 214 and extend across at least a portion of the top surface of the device body 200.

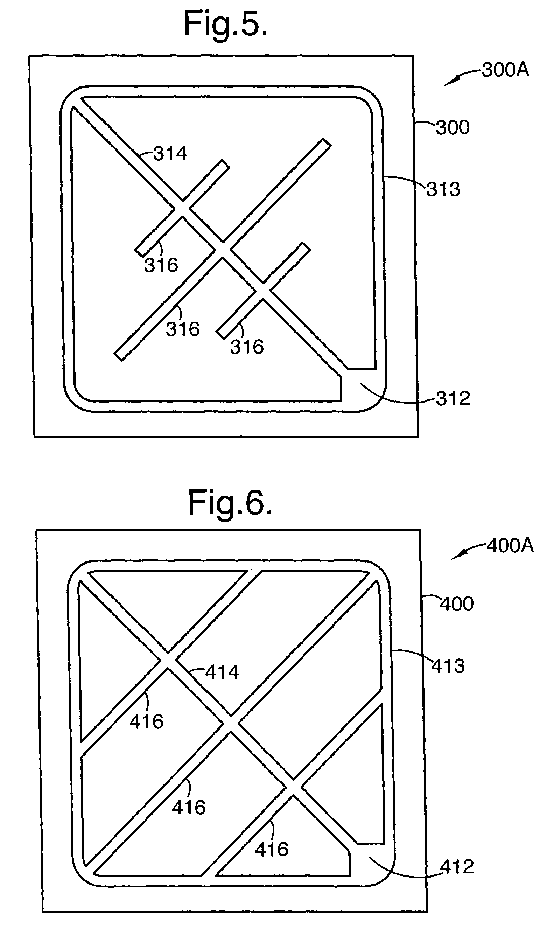

With reference to Fig. 5, a semiconductor device 300A includes a peripheral gate signal distribution runner 313 and a diagonal gate signal distribution runner 314, extending from a gate pad 312 located at a corner of a device body 300. Similar to the device 200A of Fig. 4, the device 300A of Fig. 5 includes a plurality of additional gate signal distribution runners 316 positioned perpendicular to the diagonal gate signal distribution runner 314 and extending across at least a portion of the top surface of the device body 300.

With reference to Fig. 6, a semiconductor device 400A includes a gate pad 412 located at a corner of a device body 400, with a peripheral gate signal distribution runner 413 extending around the periphery of the device body 400 and a diagonal gate signal distribution runner 414 extending diagonally across the device body 400 from the gate pad 412. In this embodiment, the additional gate signal distribution runners 416 are positioned perpendicular to the diagonal gate signal distribution runner 414 and are connected at opposite ends to the peripheral gate signal distribution runner 413.

Accordingly, a number of semiconductor devices have been described herein, which, in general, include a device body including a plurality of parallel cells, with a gate pad located on a top surface of the device body adjacent a corner of the device body. The devices further include a gate signal distribution runner having a peripheral gate signal distribution runner extending around a periphery of the device body from the gate pad and a diagonal gate signal distribution runner extending diagonally across the device body from the gate pad. The gate signal distribution runner provides a gate signal to a gate of each of the plurality of parallel cells in a uniform manner, thus, providing a semiconductor device that has more consistent propagation delays, which is especially advantageous in high frequency and/or high power applications.

Accordingly, a number of semiconductor devices have been described herein that exhibit uniform current flow through the devices during switching event. Such semiconductor devices are particularly useful in environments where high current and high power devices are increasingly utilized.

The above description is considered that of the preferred embodiments only. Modifications of the invention will occur to those skilled in the art and to those who make or use the invention. Therefore, it is understood that the embodiments shown in the drawings and described above are merely for illustrative purposes and not intended to limit the scope of the invention, which is defined by the following claims as interpreted according to the principles of patent law, including the doctrine of equivalents.

## Claims

1. A semiconductor device (400A), comprising:
a device body (400) including a plurality of parallel cells;
a gate pad (412) located on a top surface of the device body (400) adjacent a corner of the device body (400); and
a gate signal distribution runner including a peripheral gate signal distribution runner (413) extending around the periphery of the device body (400) from the gate pad (412) and a diagonal gate signal distribution runner (414) extending diagonally across the device body (400) from the gate pad (412), wherein the gate signal distribution runner provides a gate signal to a gate of each of the plurality of parallel cells.

2. The semiconductor device (400A) of claim 1, wherein the plurality of parallel cells define a metal-oxide semiconductor field-effect transistor (MOSFET).

3. The semiconductor device (400A) of claim 1, wherein the plurality of parallel cells define an insulated-gate bipolar transistor (IGBT).

4. The semiconductor device (400A) of claim 1, wherein the runner is made of one of a metal and a polysilicon.

5. The semiconductor device (400A) of claim 4, wherein the metal is aluminum.

6. The semiconductor device (400A) of claim 1, further comprising:
at least one additional gate signal distribution runner (416) positioned perpendicular to the diagonal gate signal distribution runner (414) and extending across at least a portion of the top surface of the device body (400).

7. The semiconductor device (400A) of claim 6, wherein the at least one additional gate signal distribution runner (416) is connected at opposite ends to the peripheral gate signal distribution runner (413).

8. A metal-oxide semiconductor field-effect transistor (MOSFET) (400A), comprising:
a device body (400) including a plurality of parallel cells;
a gate pad (412) located on a top surface of the device body (400) adjacent a corner of the device body (400); and
a gate signal distribution runner including a peripheral gate signal distribution runner (413) extending around the periphery of the device body (400) from the gate pad (412) and a diagonal gate signal distribution runner (414) extending diagonally across the device body (400) from the gate pad (412), wherein the gate signal distribution runner (413) provides a gate signal to a gate of each of the plurality of parallel cells.

9. The MOSFET (400A) of claim 8, wherein the runner is made of one of a metal and a polysilicon.

10. The MOSFET (400A) of claim 9, wherein the metal is aluminum.

11. The MOSFET (400A) of claim 8, further comprising:
at least one additional gate signal distribution runner (416) positioned perpendicular to the diagonal gate signal distribution runner (414) and extending across at least a portion of the top surface of the device body (400).

12. The MOSFET (400A) of claim 11, wherein the at least one additional gate signal distribution runner (416) is connected at opposite ends to the peripheral gate signal distribution runner (413).

13. The MOSFET (400A) of claim 8, wherein the runner is made of a metal and a polysilicon.

14. An insulated-gate bipolar transistor (IGBT) (400A), comprising:
a device body (400) including a plurality of parallel cells;
a gate pad (412) located on a top surface of the device body (400) adjacent a corner of the device body (400); and
a gate signal distribution runner including a peripheral gate signal distribution runner (413) extending around the periphery of the device body (400) from the gate pad (412) and a diagonal gate signal distribution runner (414) extending diagonally across the device body (400) from the gate pad (412), wherein the gate signal distribution runner (413) provides a gate signal to a gate of each of the plurality of parallel cells.

15. The IGBT (400A) of claim 14, wherein the runner is made of one of a metal and a polysilicon.

16. The IGBT (400A) of claim 15, wherein the metal is aluminum.

17. The IGBT (400A) of claim 14, further comprising:
at least one additional gate signal distribution runner (416) positioned perpendicular to the diagonal gate signal distribution runner (414) and extending across at least a portion of the top surface of the device body (400).

18. The IGBT (400A) of claim 17, wherein the at least one additional gate signal distribution runner (416) is connected at opposite ends to the peripheral gate signal distribution runner (413).

19. The IGBT (400A) of claim 14, wherein the runner is made of a metal and a polysilicon.

20. The IGBT (400A) of claim 14, wherein the at least one additional gate signal distribution runner (416) includes at least three additional gate signal distribution runners.
